# EUROPÄISCHE PATENTSCHRIFT

(11) **EP 1 064 675 B1**
(45) Veröffentlichungstag und Bekanntmachung des Hinweises auf die Patenterteilung: **31.05.2006**
(21) Anmeldenummer: 99924660.6
(22) Anmeldetag: 19.03.1999
(51) Int. Cl.: H01L 21/306

(54) **VERFAHREN ZUR HERSTELLUNG EINER MIT FLUOR BELEGTEN HALBLEITEROBERFLÄCHE**
METHOD FOR PRODUCING A SEMICONDUCTOR SURFACE COVERED WITH FLUORINE
PROCEDE DE PRODUCTION D'UNE SURFACE SEMI-CONDUCTRICE RECOUVERTE DE FLUOR

(30) Priorität: 27.03.1998 DE 19813757
(43) Veröffentlichungstag der Anmeldung: 03.01.2001
(73) Patentinhaber: Infineon Technologies AG, 81669 München (DE)
(72) Erfinder: GSCHWANDTNER, Alexander, D-80687 München (DE); INNERTSBERGER, Gudrun, D-81547 München (DE); GRASSL, Andreas, D-81735 München (DE); FRÖSCHLE, Barbara, D-89160 Dornstadt (DE); KERBER, Martin, D-81827 München (DE); MATTHEUS, Alexander, D-81547 München (DE)
(74) Vertreter: Epping - Hermann - Fischer
(86) Internationale Anmeldenummer: PCT/DE1999/000819
(87) Internationale Veröffentlichungsnummer: WO 1999/050896

(56) Entgegenhaltungen:
- US-A- 4 973 563
- US-A- 5 022 961
- US-A- 5 098 866
- US-A- 5 181 985
- Y. NISHIOKA, E.F. DA SILVA, Y. WANG, T.P. MA : "Dramatic improvement of hot-electron-induced interface degradation in MOS structures containing F or Cl in SiO2" IEE ELECTRON DEVICE LETTERS, Bd. 9, Nr. 1, 1988, Seiten 38-40, XP002110605

## Beschreibung

Die vorliegende Erfindung betrifft ein Verfahren zur Herstellung einer mit Fluor belegten Halbleiteroberfläche. Insbesondere betrifft die vorliegende Erfindung ein Verfahren zur Herstellung einer mit Fluor belegten Halbleiteroberfläche, auf der nachfolgend sogenannte "Gate-" oder "Tunneloxide" erzeugt werden können.

Zur Erhaltung bzw. Steigerung der internationalen Wettbewerbsfähigkeit ist es notwendig, die Kosten, die zur Realisierung einer bestimmten elektronische Funktion aufzuwenden sind, ständig zu senken und somit die Produktivität kontinuierlich zu steigern. Diese Steigerung der Produktivität wurde und wird vor allem durch eine erhöhte Integration der elektronischen Funktionen erreicht. Die Erhöhung der Integration der elektronischen Funktionen wiederum wird in erster Linie durch eine fortschreitende Strukturverkleinerung der einzel nen Bauelemente erreicht. Als Glücksfall ist dabei die Tatsache zu werten, daß die zusätzlichen Forderungen nach schnelleren Schaltungen sowie einer geringeren Verlustleistung ebenfalls durch den Einsatz immer kleinerer Strukturen erfüllt werden können.

Dementsprechend ist es das Ziel vieler Entwicklungen neue Verfahren zur Verfügung zu stellen, welche die Herstellung immer kleinerer Strukturen auf kostengünstige Weise gestatten. Dabei müssen die Herstellungsverfahren eine Reihe von Bedingungen erfüllen. So ist es zum einen notwendig, die Parameter der Bauelemente entsprechend der gewünschten elektronischen Funktion zu optimieren. Zum anderen ist es notwendig, eine ausreichende Stabilität dieser Parameter über die Lebensdauer des Bauelements zu gewährleisten. Leider gibt es eine Reihe von Degradationsmechanismen, die sich negativ auf die elektrischen Parameter der einzelnen Bauelemente auswirken.

Der dabei am besten untersuchte Degradationsmechanismus ist die sogenannte "HE-Degradation" (HE = Hot Elektron). Beim Betrieb eines MOS-Transistors tritt am drainseitigen Kanalrand eine Feldstärkenspitze auf, welche die Kanalelektronen bis nahe an ihre Grenzgeschwindigkeit beschleunigen kann. Einige dieser sogenannten "heißen Elektronen" können die Potentialbarriere an der Gateoxid-Grenzfläche überwinden und in das Gateoxid gelangen. Dort können diese Elektronen unter anderem Si-H Bindungen aufbrechen und somit Grenzflächenzustände erzeugen. Bei einem n-Kanal MOS-Transistor äußern sich die "Hot-Elektron-Effekte" vor allem in eine Degradation des Drainstroms. Bei einem p-Kanal MOS-Transistor äußern sich die "Hot-Elektron-Effekte" vor allem in einer Verkürzung der effektiven Kanallänge.

Neben der Degradation der Transistorparameter durch "heiße Elektronen" spielt die Degradation der Transistorparameter durch ein über einen längeren Zeitraum andauerndes Anlegen einer Gatespannung bei erhöhten Temperaturen ("Bias Temperature Stress", BTS) insbesondere für analoge bzw. gemischt analog/digitale Schaltungsfunktionen eine wichtige Rolle.

Bei analogen bzw. gemischt analog/digitalen Schaltungsfunktionen werden einige der MOS-Transistoren oft in einem Arbeitspunkt betrieben, der sehr empfindlich auf Veränderungen der Einsatzspannung des Transistors reagiert. Dieser Arbeitspunkt ist durch eine Gatespannung charakterisiert, die nur wenig über der Einsatzspannung des MOS-Transistors liegt. Dementsprechend führen auch kleine Schwankungen in der Einsatzspannung des MOS-Transistors zu relativ großen Schwankungen in dem Strom, der am Arbeitspunkt durch den MOS-Transistor fließt. Da typische Anwendungen bei analogen Schaltungsfunktionen einen möglichst gut definierten Strom durch den jeweiligen MOS-Transistor benötigen, können derartige Schwankungen in der Einsatzspannung des MOS-Transistors in der Regel nicht hingenommen werden. Leider führt die Degradation durch den "Bias Temperature Stress" (BTS) gerade zu einer Veränderung der Einsatzspannung mit den erwähnten negativen Auswirkungen auf die analogen Schaltungsfunktionen.

Auch für löschbar programmierbare Festwertspeicher (EPROM, EEPROM) spielt die Langzeitstabilität der elektrischen Parameter eine wichtige Rolle. Bei diesen Festwertspeichern sind die programmierbaren Elemente MOS-Transistoren, die jeweils ein zusätzliches, elektrisch isoliertes Polysiliziumgate ("floating gate") aufweisen. Zur Programmierung wird dieses Polysiliziumgate mit einem durch ein dünnes Oxid (Tunneldielektrikum) fließenden Tunnelstrom aufgeladen. Die tunnelnden Ladungsträger erzeugen jedoch weitere Grenzflächenzustände, was eine Erhöhung der Leitfähigkeit des Oxids bzw. eine Erniedrigung der Durchbruchsspannung zur Folge hat. Dies kann wiederum dazu führen, daß eine Speicherzelle während des Betriebs ausfällt.

Zur Vermeidung dieser Degradationsmechanismen und zur Erhöhung der Langzeitstabilität wurden eine Reihe von Maßnahmen vorgeschlagen. Als wirksame Gegenmaßnahme gegen die "HE-Degradation" wird heute in der Regel eine sogenannte "LDD-Dotierung" (LDD = "Lightly Doped Drain") der Source-/Drainbereiche eines MOS-Transistors angewandt. Diese "LDD-Dotierung" erfordert jedoch zusätzliche Prozeßschritte, was sich negativ auf die Herstellungskosten auswirkt.

Um das Problem der durch den "Bias Temperature Stress" verursachten Drift in Analogschaltungen zu lösen, wurden bisher in der Regel rein schaltungstechnische Maßnahmen ergriffen. Diese schaltungstechnischen Maßnahmen sollen verhindern, daß über einen längeren Zeitraum eine Spannung an das Gate eines MOS-Transistors angelegt wird. Die genannten schaltungstechnischen Maßnahmen komplizieren jedoch Entwurf der Schaltung und kosten außerdem zusätzliche Chipfläche, die somit nicht für andere elektronische Schaltungsfunktionen genutzt werden kann.

Weiterhin wurde vorgeschlagen, geringe Mengen an Fluor oder Chlor in die Oxidschichten einzubringen, um deren Langzeitstabilität zu erhöhen (P.J. Wright, K.C. Saraswat, "The Effect of Fluorine in Silicon Dioxide Gate Dielectrics", IEEE Transactions on Electron Devices, Vol. 36, No. 5, May 1989 oder I.C. Chen et al., "Performance and Reliability Enhancement for CVD Tungsten Polycided CMOS Transistors due to Fluorine Incorporation in the Gate Oxide", IEEE Electron Device Letters, Vol. 15, No. 9, September 1994).

Bei den bisher verwendeten Verfahren, Fluor in die Oxidschichten einzubringen, diffundiert das Fluor durch die Oxidschicht zur Halbleitergrenzfläche. Durch die Fluordiffusion wird jedoch die Struktur der Oxidschicht derart geschädigt, daß eine weitere Diffusion von Dotierstoffen durch die Oxidschicht nicht mehr ausreichend verhindert wird. Dies hat zur Folge, daß so erzielte Minderung beispielsweise der HE-Degradation in der Regel nicht ausreichend ist, um den Mehraufwand zu rechtfertigen, den eine Einbringung von Fluor oder Chlor in das Gateoxid mit sich bringt. Außerdem kann bei der Diffusion des Fluors durch die Oxidschicht die Menge an Fluor, die schließlich an der Halbleitergrenzfläche zur Verfügung steht, nur sehr ungenau festgelegt werden. Dementsprechend wird diese Methode in der Massenfertigung üblicherweise nicht eingesetzt.

Es ist daher die Aufgabe der vorliegenden Erfindung, ein Verfahren bereitzustellen, das die genannten Nachteile des Standes der Technik vermeidet oder mindert. Insbesondere ist es eine Aufgabe der vorliegenden Erfindung, ein Verfahren zur Herstellung einer mit Fluor belegten Oberfläche bereitzustellen, auf der nachfolgend Oxidschichten hoher Qualität erzeugt werden können, so daß das Problem der Degradation von Oxidschichten auf technologischem Weg gelöst oder wesentlich gemindert werden kann.

US 5 181 985 beschreibt Verfahren zur Halbeiterreinigung, bei der der Oberfläche eines Halbleitersubstrats wiederholt Wasserdampf und gasförmiger Fluorwasserstoff zugeführt werden und die Halbleiteroberfläche anschließend mit Wasser gespült wird.

US 5 098 866 beschreibt ein Verfahren zur Oxidrückätzung, bei dem zur Ätzung unter anderem Fluorwasserstoff zugeführt wird.

US 5 022 961 beschreibt ein Verfahren zur Reinigung von Halbleiteroberflächen, bei dem Fluorwasserstoff und Alkohol in Kontakt mit einer Substratoberfläche gebracht werden. Bei diesem Verfahren verbleibt eine dünne Alkoholschicht auf der Substratoberfläche. Sie dient zum Schutz vor unbeabsichtigter Oxidation und kann bei Bedarf wieder entfernt werden.

Soweit durch diese Verfahren eine Fluorschicht auf die Substratoberfläche aufgebracht wird, ist es wünschenswert, die Fluorkonzentration einstellen zu können, um zu vermeiden, daß einerseits zu wenig Fluor eingebaut wird, um ungesättigte Bindungen abzusättigen, und das andererseits zuviel Fluor eingebaut wird, wodurch Oxidstrukturen geschädigt werden könnten.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Herstellung einer mit Fluor belegten Oberfläche bereitgestellt. Das erfindungsgemäße Verfahren umfaßt folgenden sukzessiven Schritte die Schritte:
a) ein Halbleitersubstrat in einer Reaktionskammer wird bereitgestellt;
b) die Substratoberfläche wird mit Wasser und/oder Alkohol benetzt;
c) eine fluorhaltige Verbindung wird zu der Substratoberfläche geführt, so daß eine gereinigte, mit Fluor belegte Halbleiteroberfläche erzeugt wird;
d) die fluorhaltige Verbindung wird aus der Reaktionskammer entfernt; und
e) die gereinigte, mit Fluor belegte Halbleiteroberfläche wird mit einer Mischung benetzt, die zumindest 10 Vol% Wasser und zumindest 10 Vol% Alkohol enthält, so daß eine gereinigte, mit einer vorbestimmten Menge an Fluor belegt Halbleiteroberfläche erzeugt wird, auf der die vorbestimmte Menge an Fluor umso geringer ist, je höher der Wasseranteil in der Mischung gewählt wird;
f) das Wasser und der Alkohol werden von der Halbleiteroberfläche entfernt.

Durch das erfindungsgemäße Verfahren erhält man zum einen eine von Oxidrückständen gereinigte Halbleiteroberfläche. Derartige Oxidrückstände können beispielsweise durch die natürliche Oxidation der Halbleiteroberfläche oder durch Oxidreste vorangegangener Prozeßschritte verursacht werden. Durch die Reinigungswirkung des erfindungsgemäßen Verfahrens erhält man eine Halbleiteroberfläche, auf der nun weitere Schichten in hoher Qualität aufgebracht werden können.

Durch das erfindungsgemäße Verfahren kann zum anderen eine in einem weiten Bereich frei wählbare Menge an Fluor, auf die Halbleiteroberfläche gebracht werden. Bei einer nachfolgenden Erzeugung der Oxidschicht, bevorzugt durch thermisch aktivierte Oxidation, wird der Effekt ausgenutzt, daß das Fluor sowohl in das Oxid als auch an der Halbleitergrenzfläche eingebaut wird. So ist am Ende des erfindungsgemäßen Verfahrens das Fluor in der für die jeweilige Anwendung optimalen Konzentration exakt an der Stelle, an der es für die stabilisierende Wirkung notwendig sind, ohne die bisher bekannten negativen Begleiterscheinungen aufzuweisen. Durch die Möglichkeit, die Fluorkonzentration in Abhängigkeit der zu erzeugenden Bauelementklasse frei wählen zu können, wird vermieden, daß zuwenig Fluor eingebaut wird, um die ungesättigten Bindungen abzusättigen, bzw. zu viel Fluor eingebaut wird, so daß die Struktur des Oxids geschädigt wird.

Jedoch ist das vorliegende erfindungsgemäße Verfahren nicht auf die Erzeugung von Oxidschichten beschränkt. Auf die mit Fluor belegte Oberfläche kann beispielsweise auch eine Halbleiterepitaxieschicht aufgebracht werden. Die gereinigte und mit Fluor konditionierte Oberfläche gewährleistet dabei ein homogenes Wachstum der Epitaxieschicht.

Bevorzugt wird als Alkohol Methanol oder Ethanol verwendet. Weiterhin ist es bevorzugt, wenn als fluorhaltige Verbindung HF-Gas verwendet wird.

Gemäß einer bevorzugten Ausführungsform erfolgt die Benetzung der Substratoberfläche, indem das Wasser und der Alkohol in Form von Wasser- bzw. Alkoholdampf der Substratoberfläche zugeführt werden.

Bevorzugt wird nach Schritt b) der Druck in der Reaktionskammer erniedrigt, so daß nur eine dünne Benetzungsschicht, etwa ein bis zwei Monolagen, auf der Substratoberfläche verbleibt. So lassen sich gut definierte Bedingungen für die anschließende Reinigungsreaktion einstellen.

Weiterhin ist bevorzugt, wenn die fluorhaltige Verbindung durch eine Verminderung des Drucks aus der Reaktionskammer entfernt wird, wobei bevorzugt auch das Wasser und/oder der Alkohol sowie die bei der Reinigung der Substratoberfläche entstehenden Reaktionsprodukte von der Substratoberfläche entfernt werden.

Werden hohe oder sehr hohe Fluorkonzentrationen auf der gereinigten Halbleiteroberfläche benötigt, so ist es bevorzugt, wenn anschließend HF-Gas sowie Ozon und/oder Sauerstoff zu der gereinigten, mit Fluor belegten Halbleiteroberfläche geführt werden.

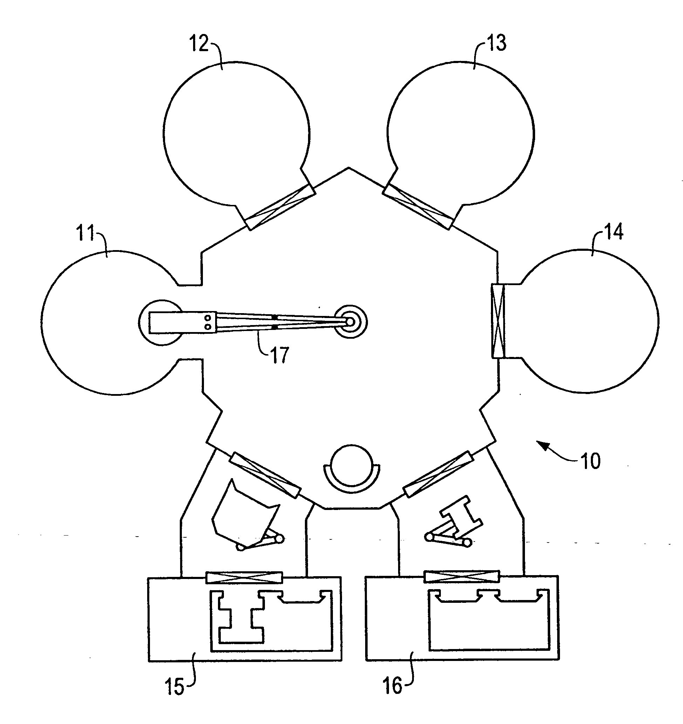

Die Erfindung wird nachfolgend anhand der Zeichnung näher dargestellt. Die Figur 1 zeigt eine schematische Darstellung eines sogenannten "Cluster Tools" zur Durchführung des erfindungsgemäßen Verfahrens.

Das in Figur 1 gezeigte Cluster Tool 10 umfaßt vier Bearbeitungskammern 11 bis 14, in denen unterschiedliche Bearbeitungsschritte an einem Siliziumwafer vorgenommen werden können. Zur Ein- bzw. Ausschleusung der Siliziumwafer weist das Cluster Tool 10 darüber hinaus sogenannte Loadlocks 15 und 16 auf. Innerhalb des Cluster Tools werden die Siliziumwafer unter definierten Bedingungen von einem Roboterarm 17 zu den einzelnen Bearbeitungskammern 11 bis 14 transportiert.

Im vorliegenden Fall ist die Bearbeitungskammer 11 zur Durchführung des erfindungsgemäßen Verfahrens vorgesehen. Dazu wird die Bearbeitungskammer 11 auf einer Temperatur von ungefähr 40°C gehalten. Dies kann beispielsweise durch einen integrierten, temperaturkontrollierten Wasserkreislauf (nicht gezeigt) erfolgen. Möglicherweise vorhandene Quarzfenster in der Bearbeitungskammer 11 können durch einen geeigneten Luftstrom auf der Temperatur gehalten werden.

Ein Siliziumwafer wird durch den Roboterarm 17 in die Bearbeitungskammer 11 eingebracht und in der Bearbeitungskammer 11 abgelegt. Dort wird der Siliziumwafer durch eine IR-Lampe ebenfalls auf etwa 40°C aufgeheitzt.

Im vorliegenden Beispiel soll das erfindungsgemäße Verfahren dazu dienen, die Erzeugung des Gateoxids vorzubereiten. Üblicherweise sind daher bereits die Isolationen, beispielsweise LOCOS-Isolationen bzw. STI-Isolationen (STI = shallow trench isolation) auf bzw. in dem Siliziumsubstrat vorhanden. Von diesen vorangehenden Prozeßschritten befinden sich in der Regel noch Oxidreste auf der Siliziumoberfläche, die die nachfolgende Erzeugung eines dünnen Gateoxids behindern würden.

Zur Reinigung und Konditionierung der Siliziumoberfläche werden daher 2slm einer Mischung aus Methanol- und Wasserdampf in Stickstoff bei einem Druck von 500 mBar für 60 Sekunden zu der Siliziumoberfläche geführt. Dabei wird der Methanol- bzw. Wasserdampf durch zwei sogenannte "Stickstoff-Bubbler", welche jeweils auf ungefähr 30°C gehalten werden, in die Bearbeitungskammer 11 geleitet. Entsprechend bildet sich auf der Scheibenoberfläche ein dünner Flüssigkeitsfilm, der die Scheibenoberfläche benetzt.

Danach wird der Druck in der Kammer auf etwa 100 mBar erniedrigt und anschließend 100 sccm HF-Gas durch eine auf 40°C beheizte Gasleitung in die Bearbeitungskammer 11 geführt. Dabei wird der Druck auf 100 mBar konstant gehalten. Nach 30 bis 60 Sekunden sind möglicherweise vorhandene Oxidreste bzw. natürliche Oxid durch die Ätzung nahezu vollständig entfernt. Dabei kommt es zu folgender Reaktion:

SiO₂ (s) + 4 HF (g) → SiF₄ (g) + 2H₂O,

welche durch die Anwesenheit der OH⁻-Gruppen des Alkohols und des Wassers katalysiert wird.

Nach der Ätzung wird der Druck in der Bearbeitungskammer auf einen Wert kleiner 0,5 mBar verringert, so daß das HF-Gas aus der Bearbeitungskammer entfernt wird. Anschließend werden 2slm einer Mischung aus Wasser- und Alkoholdampf in Stickstoff bei einem Druck von 500mBar für 60 Sekunden zu der gereinigten Siliziumoberfläche geführt. Dabei gilt, daß je höher der Wasseranteil (maximal 90%) gewählt wird, desto geringer ist die verbleibende Fluorkonzentration an der Siliziumoberfläche. Man erhält somit eine nahezu vollständig gereinigte Siliziumoberfläche, deren oberste Schicht zu <1% bis 30% mit Fluor belegt ist.
Danach wird der Druck in der Bearbeitungskammer 11 wiederum auf einen Wert kleiner 0,5 mBar verringert, so daß das Wasser und der Alkohol durch Verdampfung von der Siliziumoberfläche entfernt werden.

So ist am Ende des erfindungsgemäßen Verfahrens das Fluor in der für die jeweilige Anwendung optimalen Konzentration exakt an der Stelle, an der sie für die stabilisierende Wirkung notwendig sind. Durch die Möglichkeit, die Fluorkonzentration in Abhängigkeit der zu erzeugenden Bauelementklasse frei wählen zu können, wird vermieden, daß zuwenig Fluor eingebaut wird, um die ungesättigten Bindungen am Silizium/Siliziumoxid-Interface abzusättigen, bzw. zu viel Fluor eingebaut wird, so daß die Struktur des nachfolgend zu erzeugenden Oxids geschädigt wird.

Sollte für eine Anwendung besonders hohe Konzentrationen von Fluor an der Siliziumoberfläche benötigt werden, so kann dies durch einen nachfolgenden Behandlungschritt mit einer fluorhaltigen Verbindung eingestellt werden.

Dazu wird in bevorzugter Weise eine Mischung aus Ozon und Sauerstoff (Anteil des Ozons an diesem Gemisch zwischen 0,5% und 15%) sowie HF-Gas bei einer Temperatur von etwa 40°C bis 700°C und einem Druck von etwa 1000 mBar in die Bearbeitungskammer 11 geleitet. Dadurch wird eine sehr dünne Oxidschicht mit einer hohen Fluorkonzentration erzeugt.

Als Alternative können auch Sauerstoff und HF-Gas bei einer erhöhten Temperatur von über 700°C in die Bearbeitungskammer 11 geleitet werden. Dadurch wird ebenfalls eine sehr dünne Oxidschicht mit einer hohen Fluorkonzentration erzeugt.

Ist die Reinigung und Konditionierung der Siliziumoberfläche abgeschlossen, wird der Siliziumwafer von dem Roboterarm 17 aus der Bearbeitungskammer entfernt und beispielsweise zu der Bearbeitungskammer 12 gebracht, wo durch thermische Oxidation oder durch eine CVD-Abscheidung eine dünne Gateoxidschicht erzeugt wird.

## Patentansprüche

1. Verfahren zur Herstellung einer mit Fluor belegten Oberfläche mit den folgenden sukzessiven Schritten Schritten :
a) ein Halbleitersubstrat in einer Reaktionskammer wird bereitgestellt;
b) die Substratoberfläche wird mit Wasser und/oder Alkohol benetzt;
c) eine fluorhaltige Verbindung wird zu der Substratoberfläche geführt, so daß eine gereinigte, mit Fluor belegte Halbleiteroberfläche erzeugt wird;
d) die fluorhaltige Verbindung wird aus der Reaktionskammer entfernt;
**gekennzeichnet durch** die weiteren Schritte:
e) die gereinigte, mit Fluor belegte Halbleiteroberfläche wird mit einer Mischung benetzt, die zumindest 10 Vol% Wasser und zumindest 10 Vol% Alkohol enthält, so daß eine gereinigte, mit einer vorbestimmten Menge an Fluor belegte Halbleiteroberfläche erzeugt wird, auf der die vorbestimmte Menge an Fluor umso geringer ist, je höher der Wasseranteil in der Mischung gewählt wird;
f) das Wasser und der Alkohol werden von der Halbleiteroberfläche entfernt.

2. Verfahren nach Anspruch 1, **dadurch gekennzeichnet, daß** als Alkohol Methanol oder Ethanol verwendet wird.

3. Verfahren nach Anspruch 1 oder 2, **dadurch gekennzeichnet, daß** als fluorhaltige Verbindung HF-Gas verwendet wird.

4. Verfahren nach einem der vorstehenden Ansprüche, **dadurch gekennzeichnet, daß** das Wasser und der Alkohol in Form von Wasser- bzw. Alkoholdampf der Substratoberfläche zugeführt werden.

5. Verfahren nach einem der vorstehenden Ansprüche, **dadurch gekennzeichnet, daß** nach Schritt b) der Druck in der Reaktionskammer erniedrigt wird, so daß nur eine dünne Benetzungsschicht auf der Substratoberfläche verbleibt.

6. Verfahren nach einem der vorstehenden Ansprüche, **dadurch gekennzeichnet, daß** die fluorhaltige Verbindung durch eine Verminderung des Drucks aus der Reaktionskammer entfernt wird, wobei bevorzugt auch das Wasser und/oder der Alkohol sowie die bei der Reinigung der Substratoberfläche entstehenden Reaktionsprodukte von der Substratoberfläche entfernt werden.

7. Verfahren nach einem der Ansprüche 1 bis 6, **dadurch gekennzeichnet, daß** anschließend HF-Gas sowie Ozon und/oder Sauerstoff zu der gereinigten, mit Fluor belegten Halbleiteroberfläche geführt werden.

## Claims

1. Process for producing a surface covered with fluorine, having the following successive steps:
a) a semiconductor substrate is provided in a reaction chamber;
b) the substrate surface is wetted with water and/or alcohol;
c) a compound containing fluorine is led to the substrate surface, so that a cleaned semiconductor surface covered with fluorine is produced;
d) the compound containing fluorine is removed from the reaction chamber; and
**characterized by** the further steps:
e) the cleaned semiconductor surface covered with fluorine is wetted with a mixture which contains at least 10% by volume of water and at least 10% by volume of alcohol, so that a cleaned semiconductor surface covered with a predetermined amount of fluorine is produced, on which the predetermined amount of fluorine is lower the higher the proportion of water in the mixture is chosen to be;
f) the water and the alcohol are removed from the semiconductor surface.

2. Process according to Claim 1, **characterized in that** the alcohol used is methanol or ethanol.

3. Process according to Claim 1 or 2, **characterized in that** HF gas is used as the compound containing fluorine.

4. Process according to one of the preceding claims, **characterized in that** the water and the alcohol are fed to the substrate surface in the form of water vapour and alcohol vapour.

5. Process according to one of the preceding claims, **characterized in that** following step b), the pressure in the reaction chamber is lowered, so that only a thin wetting layer remains on the substrate surface.

6. Process according to one of the preceding claims, **characterized in that** the compound containing fluorine is removed from the reaction chamber by reducing the pressure, it being preferable for the water and/or the alcohol and the reaction products produced during the cleaning of the substrate surface to be removed from the substrate surface as well.

7. Process according to one of Claims 1 to 6, **characterized in that** HF gas and ozone and/or oxygen are subsequently fed to the cleaned semiconductor surface covered with fluorine.

## Revendications

1. Procédé de production d'une surface recouverte de fluor comprenant les stades successifs suivants :
a) on met un substrat semi-conducteur dans une chambre de réaction ;
b) on mouille la surface du substrat par de l'eau et/ou par de l'alcool ;
c) on fait passer un composé fluoré à la surface de substrat, de manière à produire une surface semi-conductrice purifiée et recouverte de fluor ;
d) on enlève le composé fluoré de la chambre de réaction ;
**caractérisé par** les autres stades :
e) on mouille la surface semi-conductrice purifiée et recouverte de fluor par un mélange qui contient au moins 10 % en volume d'eau et au moins 10 % en volume d'alcool, de manière à produire une surface semi-conductrice purifiée recouverte d'une quantité déterminée à l'avance de fluor, et sur laquelle la quantité déterminée à l'avance de fluor est d'autant plus petite que la proportion d'eau dans le mélange a été choisie plus grande ;
f) on enlève l'eau et l'alcool de la surface semi-conductrice.

2. Procédé suivant la revendication 1, **caractérisé en ce qu'**on utilise comme alcool du méthanol ou de l'éthanol.

3. Procédé suivant la revendication 1 ou 2, **caractérisé en ce qu'**on utilise du HF gazeux comme composé fluoré.

4. Procédé suivant l'une des revendications précédentes, **caractérisé en ce que** l'on envoie l'eau et l'alcool sous la forme de vapeur d'eau ou de vapeur d'alcool à la surface du substrat.

5. Procédé suivant l'une des revendications précédentes, **caractérisé en ce qu'**après le stade b), on abaisse la pression dans la chambre de réaction, de manière à ne laisser subsister qu'une mince couche de mouillage sur la surface du substrat.

6. Procédé suivant l'une des revendications précédentes, **caractérisé en ce que** l'on enlève le composé fluoré de la chambre de réaction par une diminution de la pression, l'eau et/ou l'alcool ainsi que les produits de réaction se formant lors du nettoyage de la surface du filtrat étant de préférence enlevés aussi de la surface du substrat.

7. Procédé suivant l'une des revendications 1 à 6, **caractérisé en ce que** l'on fait passer un fluide dit HF gazeux ainsi que de l'ozone et/ou de l'oxygène sur la surface semi-conductrice purifiée et recouverte de fluor.
